# EUROPEAN PATENT SPECIFICATION

(11) **EP 2 139 929 B1**
(45) Date of publication and mention of the grant of the patent: **08.10.2014**
(21) Application number: 08744916.1
(22) Date of filing: 02.04.2008
(51) Int. Cl.: C08F 20/34, G03G 5/05

(54) **POLYCARBAZOLYL(METH)ACRYLATE LIGHT EMISSIVE COMPOSITIONS**
LICHTEMITTIERENDE POLYCARBAZOLYL(METH)ACRYLATZUSAMMENSETZUNGEN
COMPOSITIONS ÉLECTROLUMINESCENTES DE POLYCARBAZOLYL(METH)ACRYLATE

(30) Priority: 17.04.2007 US 736023
(43) Date of publication of application: 06.01.2010
(73) Proprietor: General Electric Company, Schenectady, NY 12345 (US)
(72) Inventor: YE, Qing, Schenectady, NY 12309 (US); LIU, Jie, Niskayuna, NY 12309 (US)
(74) Representative: Szary, Anne Catherine
(86) International application number: PCT/US2008/059106
(87) International publication number: WO 2008/130805

(56) References cited:
- EP-A- 0 385 377
- SERGEY LAMANSKY, PETER DJUROVICH, DREW MURPHY, FERAS ABDEL-RAZZAQ, HAE-EUN LEE: "Highly Phosphorescent B is-Cyclometalated Iridium Complexes: Synthesis, Photophysical Characterization, and Use in Organic Light Emitting Diodes" J AM. CHEM. SOC., vol. 123, no. 18, 9 May 2001 (2001-05-09), pages 4304-4312, XP002483262
- ATSUSHI AOKI, YURI TAMAGAWA, AND TOKUJI MIYASHITA: "Effect of Hole-Transporting Film Thickness on the Performance of Electroluminescent Devices Using Polymer Langmuir?Blodgett Films Containing Carbazole" MACROMOLECULES, vol. 35, no. 9, 23 April 2002 (2002-04-23), pages 3686-3689, XP002483263

## Description

### CROSS-REFERENCE TO RELATED APPLICATIONS

This application is related to U.S. patent application entitled "Polycarbazolyl(Meth) Acrylate Light Missive Compositions," filed concurrently herewith as attorney docket number 206738-2, the entire contents of which are incorporated herein by reference.

### BACKGROUND

Organic light emitting devices (OLEDs), which make use of thin film materials that emit light when subjected to a voltage bias, are expected to become an increasingly popular form of flat panel display technology. This is because OLEDs have a wide variety of potential applications, including cellphones, personal digital assistants (PDAs), computer displays, information displays in vehicles, television monitors, as well as light sources for general illumination. Due to their bright colors, wide viewing angle, compatibility with full motion video, broad temperature ranges, thin and conformable form factor, low power requirements and the potential for low cost manufacturing processes, OLEDs are seen as a future replacement technology for cathode ray tubes (CRTs) and liquid crystal displays (LCDs). Due to their high luminous efficiencies, OLEDs are seen as having the potential to replace incandescent, and perhaps even fluorescent, lamps for certain types of applications.

One approach to achieve full-color OLEDs includes energy transfer from host to emissive guest molecules. For this to be realized, the triplet energy state of the host has to be higher than the guest molecule. Carbazole derivatives have shown promise to perform well as host molecule in the presence of metal containing emissive guest molecules. Often used in this respect is poly(N-vinyl carbazole) (PVK). But PVK is not an ideal host candidate since its triplet energy gap is about 2.5eV. Iridium (III) bis (4,6-difluorophenyl pyridinato-N,C²-picolinato) (FIrpic) is a blue phosphorescent dye which when used in OLEDs exhibits high quantum efficiency. The triplet energy gap for FIrpic is 2.7 eV which is greater than the triplet energy gap for PVK, resulting in reduced quantum efficiency in the devices. Thus, there is a need in the art to develop OLEDs having polymers with high triplet energy gaps, while still maintaining the potential for the molecules to host red, green, and blue emissive complexes.

### BRIEF DESCRIPTION

In one embodiment, the present invention relates to compositions comprising at least one phosphorescent organometallic compound and a polymer comprising structural units derived from at least one monomer of formula I 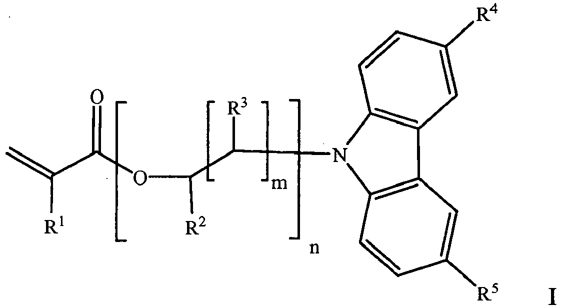 wherein R¹ is H or CH₃; R² is H or C₁-C₅ alkyl; R³ is H or CH₃; R⁴ and R⁵ are independently H, CH₃, t-butyl, triarylsilyl, trialkylsilyl, diphenyl phosphine oxide, or diphenyl phosphine sulfide; m ranges from about 1 to about 20; and n ranges from about 1 to about 20.

In another aspect, the present invention relates to organic light emitting devices comprising at least one electrode, at least one charge injection layer, at least one light emissive layer comprising at least one phosphorescent organometallic compound and a polymer comprising structural units derived from at least one monomer of formula I.

### DRAWINGS

These and other features, aspects, and advantages of the present invention will become better understood when the following detailed description is read with reference to the accompanying drawings in which like characters represent like parts throughout the drawings, wherein:
FIG. 1 shows the phosphorescent spectra of poly(2-(9-carbazolyl)-ethyl methacrylate) (dotted line) and FIrpic (1wt%) dispersed in polystyrene (PS) (solid line).
FIG. 2 shows time resolved PL profile of Sample 1 (solid line) poly(2-(9-carbazolyl)-ethyl methacrylate) versus Sample 3 (dotted line) which is a PS-control.
FIG. 3 shows time resolved PL profile of Sample 2 (solid line) which is a poly(2-(9-carbazolyl)-ethyl acrylate) versus Sample 3 (dotted line) which is a PS-control.
FIG. 4 shows the time resolved PL profile of a comparative sample comprising PVK (solid line) versus a control comprising PS (dotted line).
FIG. 5 shows the electroluminescence spectra of blue phosphorescent OLEDs having PVK (solid line) and poly(2-(9-carbazolyl)-ethyl methacrylate) (dotted line) as the host, respectively.
FIG. 6 shows the efficiency *vs* brightness of blue phosphorescent OLEDs having PVK (diamonds) and poly(2-(9-carbazolyl)-ethyl methacrylate) (triangles) as the host, respectively.

### DETAILED DESCRIPTION

Polymers for use in the compositions and devices of the present invention include structural units derived from a monomer of formula I, which are methacrylate monomers having pendant carbazolyl groups. In some cases, the 3, 6 positions of the carbazole unit may be susceptible to oxidative coupling reactions, and it may be advantageous to protect one or more of these positions. Thus, in some embodiments, R⁴ and R⁵ are t-butyl groups, while in still other embodiments, R⁴ and R⁵ are trialkylsilyl and triarylsilyl groups, and in yet other embodiments, they are diphenyl phosphine oxide or diphenyl phosphine sulfide. A wide variety of other groups may also be used to protect the carbazole at the 3 and 6 positions, and these may include, but not limited to, methyl, ethyl, methoxy, tolyl, methylcyclohexyl, and halomethyl. In other embodiments, R⁴ and R⁵ are hydrogen, and the carbazole unit is unprotected at the 3 and 6 positions.

Monomers of formula I may be obtained in high yields by following synthetic procedures known in the art. Monomers of formula I are esters of (meth)acrylic acid and may be synthesized, for example, by the esterification reaction between (meth)acryloyl chloride and N-(2-hydroxyethyl)carbazole. The monomers are also commercially available from sources such as Aldrich Chemical Company, Milwaukee, WI. Those skilled in the art will recognize that depending on the synthetic method utilized, the value of n and m may be an integer having a specific value, or may be a distribution and is represented as an average.

In one particular aspect, the values of n and m are 1, and the monomer has formula 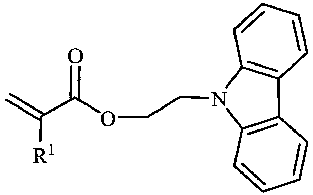 wherein R¹ is H or CH₃. In one particular embodiment, R¹ is CH₃, and the monomer is a methacrylate ester of formula

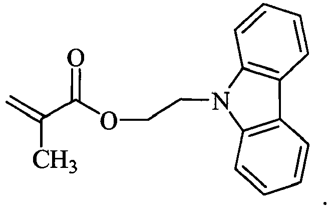

In another particular embodiment, R¹ is a H, and the monomer is an acrylate ester of formula

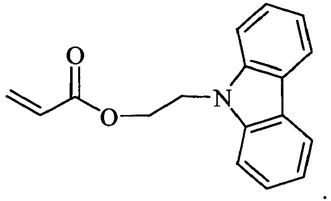

The monomers 2-(9-carbazolyl)-ethyl methacrylate, 2-(9-carbazolyl)-ethyl acrylate, and the polymers poly(2-(9-carbazolyl)-ethyl acrylate) and poly(2-(9-carbazolyl)-ethyl methacrylate) are also commercially available from various sources, such as Aldrich Chemical Company, Milwaukee, WI.

In some embodiments, the polymer useful in the invention is a homopolymer. In other embodiments, the polymer is a copolymer and additionally includes structural units derived from (meth)acrylic acid, esters of (meth)acrylic acid, (meth)acrylic amides, vinyl aromatic monomers, substituted ethylene monomers, and combinations thereof. The copolymer may be a block copolymer, a random copolymer, an alternating copolymer, or a graft copolymer. The different kinds of copolymers may be obtained by the appropriate choice of monomers, reaction conditions such as initiators, temperature, and/or solvent.

Polymers useful in the invention may be made by the polymerization of monomers effected by initiators that include free radical initiators, cationic initiators, anionic initiators, and the like. Polymerization may be effected in the bulk state, in solution using a suitable solvent, or in an appropriate suspension or emulsion state. In one particular embodiment, the polymerization is effected using free radical initiators such as azobisisobutyronitrile in a nonpolar solvent such as benzene or toluene.

Methods for polymerizing (meth)acrylate monomers are well known in the art. In certain embodiments, the polymerization reaction may be conducted at a temperature that ranges from about -78°C to about 100°C. The polymerization may also be conducted at atmospheric pressure, subatmospheric pressures, or superatmospheric pressures. The polymerization reaction is conducted for a time period necessary to achieve polymer of a suitable molecular weight. The molecular weight of a polymer is determined by any of the techniques known to those skilled in the art, and include viscosity measurements, light scattering, osmometry, and the like. The molecular weight of a polymer is typically represented as a number average molecular weight Mₙ, or weight average molecular weight, M_{w}. A particularly useful technique to determine molecular weight averages is gel permeation chromatography (GPC), from wherein both number average and weight average molecular weights are obtained. In some embodiments, it is desirable that M_{w} of the polymer is sufficiently high to allow film formation, typically greater than about 5,000 grams per mole (g/mol) is desirable, in other embodiments, polymers of M_{w} greater than 30,000 g/mol is desirable, while in yet other embodiments, polymer of M_{w} greater than 70,000 g/mol is desirable. M_{w} is determined using polystyrene as standard.

Phosphorescent organometallic compound for use in the compositions and devices of the present invention are of formula L₂MZ wherein L and Z are independently bidentate ligands; M is Ga, Al, Sc, Ti, V, Cr, Mn, Fe, Co, Ni, Cu, Zn, Y, Zr, Nb, Mo, Tc, Ru, Rh, Pd, Ag, Cd, Lu, Hf, Ta, W, Re, Os, Ir, Pt, Au, Hg, Ga, Ge, In, Sn, Sb, Tl, Pb, Bi, Eu, Tb, La, Po, or a combination thereof.

In one embodiment, M is iridium, and the phosphorescent organometallic compound is an organic iridium composition.

In some embodiments, L is a cyclometallated ligand. In some specific embodiments, L and Z are independently derived from phenylpyridine, tolylpyridine, benzothienylpyridine, phenylisoquinoline, dibenzoquinozaline, fluorenylpyridine, ketopyrrole, picolinate, acetylacetonate hexafluoroacetylacetonate, salicylidene, 8-hydroxyquinolinate; amino acid, salicylaldehyde, iminoacetonate, 2-(1-naphthyl)benzoxazole)), 2-phenylbenzoxazole, 2-phenylbenzothiazole, coumarin, thienylpyridine, phenylpyridine, benzothienylpyridine, 3-methoxy-2-phenylpyridine, thienylpyridine, phenylimine, vinylpyridine, pyridylnaphthalene, pyridylpyrrole, pyridylimidazole, phenylindole, derivatives thereof or combinations thereof.

In some embodiments, the at least one phosphorescent organometallic compound is a compound of formula 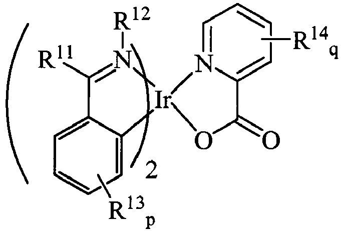 wherein R¹¹ and R¹² taken together form a substituted or unsubstituted monocyclic or bicyclic heteroaromatic ring; R¹³ and R¹⁴ are independently at each occurrence halo, nitro, hydroxy, amino, alkyl, aryl, arylalkyl, alkoxy, substituted alkoxy, substituted alkyl, substituted aryl, or substituted arylalkyl; p and q are independently 0, or integers ranging from 1 to 4. In particular embodiments, L is derived from a phenyl pyridine, and/or Z is derived from picolinate. In one specific embodiment, M is iridium, L is derived from 2-(4,6-difluorophenyl) pyridine, and Z is derived from picolinic acid, and the phosphorescent organometallic compound has formula

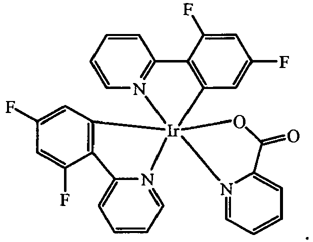

This organic iridium compound (FIrpic) is a known blue phosphorescent dye. This organic iridium composition is commercially available from various sources, such as American Dye Sources, Quebec, Canada. Alternately, it may be synthesized by first reacting the cyclometallating ligand 2-(4,6-difluorophenyl)pyridine with iridium (III) chloride under suitable reaction conditions to afford the chloride-bridged cyclometallated iridium dimer intermediate, followed by reacting the intermediate with picolinic acid under suitable reaction conditions to afford the organic iridium composition.

In some other embodiments, the phosphorescent dye may be a red phosphorescent dye, a green phosphorescent dye, a blue phosphorescent dye, or combinations thereof.

Exemplary blue phosphorescent dyes include, but are not limited to,

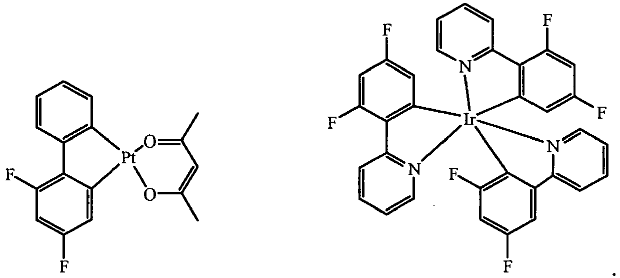

Exemplary green phosphorescent dyes include, but are not limited to,

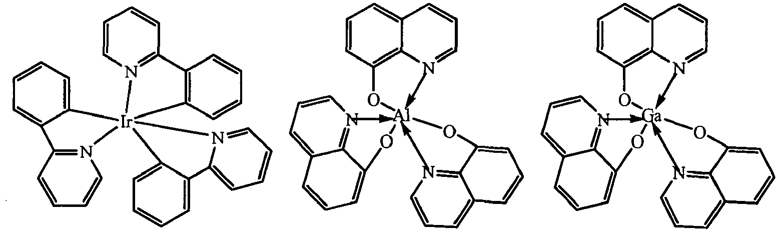

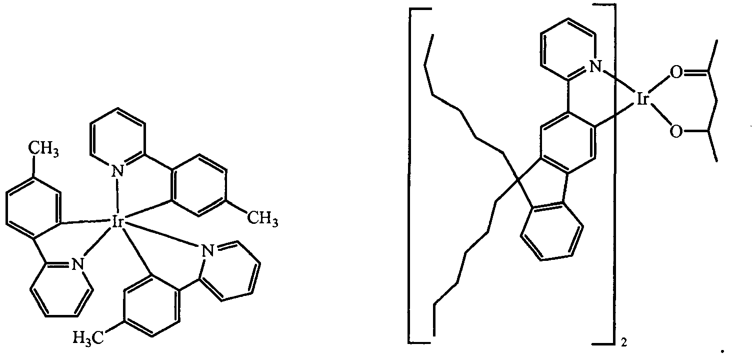

Exemplary red phosphorescent dyes include, but are not limited to,

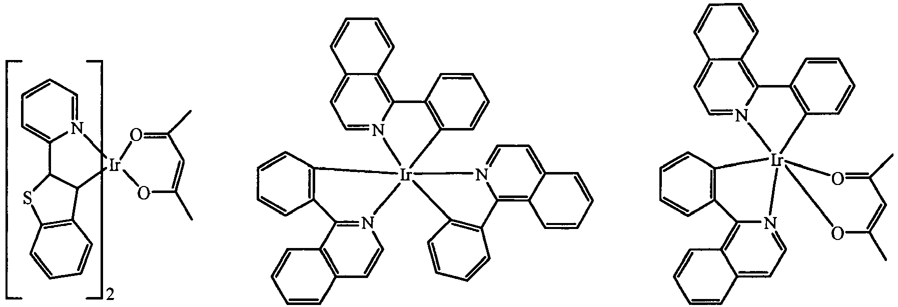

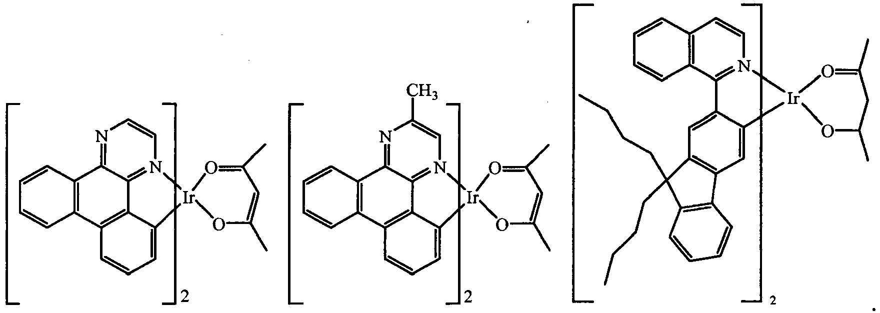

Phosphorescent organometallic compounds as described herein, may be synthesized by standard techniques as described earlier, or by other techniques known in the art. Alternately, the phosphorescent organometallic compounds of the invention may be obtained from commercial sources, such as American Dye Sources, Quebec, Canada.

In one embodiment, the at least one phosphorescent organometallic compound is present in an amount ranging from about 0.01 mole percent to about 25 mole percent with respect to the number of moles of the structural unit derived from the monomer of formula I. In another embodiment, the at least one phosphorescent organometallic compound is present in an amount ranging from about 0.1 mole percent to about 10 mole percent. Alternately, the amount of the organometallic compound may be expressed as weight percent of the total weight of the polymer; in such cases, the amount of the organometallic compound ranges from about 0.1 weight percent to about 40 weight percent.

In another aspect, the present invention relates to polymers that include structural units derived from a monomer of formula I, and a polymerizable phosphorescent organometallic compound of formula L'₂MZ', wherein L' and Z' are independently bidentate ligands; at least one of L' and Z' comprises at least one substituent selected from C₂₋₂₀ alkenyl, C₂₋₂₀ alkynyl, C₂₋₂₀ substituted alkenyl, C₂₋₂₀ substituted alkynyl, C₂₋₂₀ alkenyloxy, C₂₋₂₀ alkynyloxy, styryl, acryloyl, and methacryloyl; and M is Ga, Al, Sc, Ti, V, Cr, Mn, Fe, Co, Ni, Cu, Zn, Y, Zr, Nb, Mo, Tc, Ru, Rh, Pd, Ag, Cd, Lu, Hf, Ta, W, Re, Os, Ir, Pt, Au, Hg, Ga, Ge, In, Sn, Sb, Tl, Pb, Bi, Eu, Tb, La, Po, or a combination thereof.

In some embodiments, M is Tc, Ru, Rh, Pd, Re, Os, Ir, Pt, or a combination thereof. In other embodiments, M is Ru, Pd, Os, Ir, Pt, or a combination thereof. In one specific embodiment, M is Ir and the polymerizable phosphorescent organometallic compound is an organic iridium composition.

In one embodiment, L' is a cyclometallated ligand. In some embodiments, L' and Z' are independently derived from phenylpyridine, tolylpyridine, benzothienylpyridine, phenylisoquinoline, dibenzoquinozaline, fluorenylpyridine, ketopyrrole, picolinate, acetylacetonate, hexafluoroacetylacetonate, salicylidene, 8-hydroxyquinolinate; amino acid, salicylaldehyde, iminoacetonate, 2-(1-naphthyl)benzoxazole)), 2-phenylbenzoxazole, 2-phenylbenzothiazole, coumarin, thienylpyridine, phenylpyridine, benzothienylpyridine, 3-methoxy-2-phenylpyridine, thienylpyridine, phenylimine, vinylpyridine, pyridylnaphthalene, pyridylpyrrole, pyridylimidazole, phenylindole, derivatives thereof or combinations thereof. In some other specific embodiments, L' is derived from 1-phenylisoquinoline, 2-phenylpyridine, a derivative thereof, or a combination thereof.

In some specific embodiments, the polymerizable organometallic compound is a compound of formula 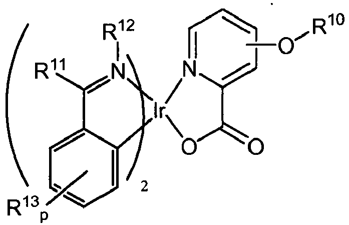 wherein R¹⁰ is C₂₋₂₀ alkenyl, C₂₋₂₀ alkynyl, C₂₋₂₀ substituted alkenyl, C₂₋₂₀ substituted alkynyl, C₂₋₂₀ alkynyloxy, styryl, acryloyl, methacryloyl or a combination thereof; R¹¹ and R¹² taken together form a substituted or unsubstituted monocyclic or bicyclic heteroaromatic ring; R¹³ is independently at each occurrence halo, nitro, hydroxy, amino, alkyl, aryl, arylalkyl, alkoxy, substituted alkoxy, substituted alkyl, substituted aryl, or substituted arylalkyl; and p is 0, or is an integer that ranges from 1 to 4. The group R¹⁰ is polymerizable group on the organometallic compound, and is a styryl group in one embodiment, a methacryloyl group in another embodiment, and an acryloyl group in yet another embodiment.

In particular embodiments, L' is derived from a phenyl pyridine, and/or Z' is derived from picolinate, and comprises at least one substituent selected from C₂₋₂₀ alkenyl, C₂₋₂₀ alkynyl, C₂₋₂₀ substituted alkenyl, C₂₋₂₀ substituted alkynyl, C₂₋₂₀ alkenyloxy, C₂₋₂₀ alkynyloxy, styryl, acryloyl, and methacryloyl. In one specific embodiment, M is iridium, L is derived from 2-(4,6-difluorophenyl) pyridine, and Z is derived from a hydroxypicolinic acid, and the polymerizable phosphorescent organometallic compound has formula compound of formula 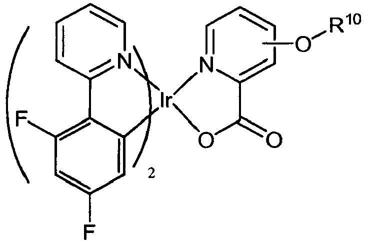 wherein R¹⁰ is C₂₋₂₀ alkenyl, C₂₋₂₀ alkynyl, C₂₋₂₀ substituted alkenyl, C₂₋₂₀ substituted alkynyl, C₂₋₂₀ alkynyloxy, styryl, acryloyl, methacryloyl or a combination thereof.

Polymerizable phosphorescent organometallic compounds of the invention may be prepared in a multistep process. Thus, in one embodiment, a first intermediate may be prepared by heating a ligand precursor, such as 2-(4,6-difluorophenyl)pyridine, with metal halide, such as IrCl₃, in the presence of a solvent such as aqueous 2-methoxyethanol, to afford the chloride-bridged cyclometallated iridium dimer intermediate (e.g. {(Fppy)₂Ir(µ-Cl)}₂). The chloride-bridged cyclometallated iridium dimer intermediate may be reacted with a functionalized ancillary ligand such as 4-hydroxy picolinic acid, in the presence of a base to afford the corresponding functionalized organic iridium complex. Subsequently, the organic iridium complex is reacted with a suitable organic reactant comprising a vinyl group and a functional group that can react with the functionalized organic iridium complex to provide the polymerizable phosphorescent organometallic compound. Some of the intermediates described herein may also be available from commercial sources, such as Aldrich Chemical Company, Milwaukee, WI, or American Dye Sources, Quebec, Canada.

In one embodiment, the at least one polymerizable phosphorescent organometallic compound is present in an amount ranging from about 0.1 mole percent to about 25 mole percent with respect to the total number of moles of the monomer having formula I. In another embodiment, the at least one polymerizable phosphorescent organometallic compound is present in an amount ranging from about 1 mole percent to about 10 mole percent with respect to the total number of moles with respect to the total number of moles of monomer having formula I.

Compositions and polymers provided in the present invention may find use in a wide variety of applications that include, but are not limited to, light emitting electrochemical cells, photo detectors, photo conductive cells, photo switches, display devices and the like. Thus, in one aspect, the invention provides a light emitting comprising at least one electrode, at least one hole injection layer, at least one light emissive layer; wherein the light emissive layer comprises a composition comprising at least one phosphorescent organometallic compound and at least one polymer having structural units derived from at least one monomer of formula I. In another aspect, the invention provides a light emitting comprising at least one electrode, at least one hole injection layer, at least one light emissive layer; wherein the light emissive layer comprises a composition comprising at least one polymer having structural units derived from at least one monomer of formula I and structural units derived from a polymerizable phosphorescent organometallic compound.

The compositions of the present invention are particularly well suited for use in an electroactive layers in organic light emitting devices. In one embodiment, the present invention provides an organic light emitting device comprising an electroactive layer which consists essentially of a composition or polymer of the invention. In another embodiment, the present invention provides an organic light emitting device comprising the composition or polymer of the invention as a constituent of an electroactive layer of an organic light emitting device. In one embodiment, the present invention provides an organic light emitting device comprising the composition or polymer of the invention as a constituent of a light emitting electroactive layer of an organic light emitting device.

An organic light emitting device typically comprises multiple layers which include in the simplest case, an anode layer and a corresponding cathode layer with an organic electrophosphorescent layer disposed between said anode and said cathode. When a voltage bias is applied across the electrodes, electrons are injected from the cathode into the electrophosphorescent layer while electrons are removed from (or "holes" are "injected" into) the electroluminescent layer from the anode. Light emission occurs as holes combine with electrons within the electrophosphorescent layer to form singlet or triplet excitons, light emission occurring as singlet excitons transfer energy to the environment by radiative decay.

Other components which may be present in an organic light emitting device in addition to the anode, cathode, and light emitting material include hole injection layers, electron injection layers, and electron transport layers. The electron transport layer need not be in contact with the cathode, and frequently the electron transport layer is not an efficient hole transporter and thus it serves to block holes migrating toward the cathode. During operation of an organic light emitting device comprising an electron transport layer, the majority of charge carriers (i.e. holes and electrons) present in the electron transport layer are electrons and light emission can occur through recombination of holes and electrons present in the electron transport layer. Additional components which may be present in an organic light emitting device include hole transport layers, hole transporting emission (emitting) layers and electron transporting emission (emitting) layers.

Polymers comprising structural units derived from monomers of formula I have triplet energy states that are useful in applications such as organic light emitting devices (OLEDs), as they may give rise to highly efficient devices. Further, the triplet energy of these polymers may be high enough that it may be greater than those of the phosphorescent dyes used in devices, and thus may serve as host molecules.

The organic electroluminescent layer is a layer within an organic light emitting device which when in operation contains a significant concentration of both electrons and holes and provides sites for exciton formation and light emission. A hole injection layer is a layer in contact with the anode which promotes the injection of holes from the anode into the interior layers of the OLED; and an electron injection layer is a layer in contact with the cathode that promotes the injection of electrons from the cathode into the OLED; an electron transport layer is a layer which facilitates conduction of electrons from cathode to a charge recombination site. The electron transport layer need not be in contact with the cathode, and frequently the electron transport layer is not an efficient hole transporter and thus it serves to block holes migrating toward the cathode. During operation of an organic light emitting device comprising an electron transport layer, the majority of charge carriers (i.e. holes and electrons) present in the electron transport layer are electrons and light emission can occur through recombination of holes and electrons present in the electron transport layer. A hole transport layer is a layer which when the OLED is in operation facilitates conduction of holes from the anode to charge recombination sites and which need not be in contact with the anode. A hole transporting emission layer is a layer in which when the OLED is in operation facilitates the conduction of holes to charge recombination sites, and in which the majority of charge carriers are holes, and in which emission occurs not only through recombination with residual electrons, but also through the transfer of energy from a charge recombination zone elsewhere in the device. An electron transporting emission layer is a layer in which when the OLED is in operation facilitates the conduction of electrons to charge recombination sites, and in which the majority of charge carriers are electrons, and in which emission occurs not only through recombination with residual holes, but also through the transfer of energy from a charge recombination zone elsewhere in the device.

Materials suitable for use as the anode include materials having a bulk conductivity of at least about 100 ohms per square, as measured by a four-point probe technique. Indium tin oxide (ITO) is frequently used as the anode because it is substantially transparent to light transmission and thus facilitates the escape of light emitted from electro-active organic layer. Other materials which may be utilized as the anode layer include tin oxide, indium oxide, zinc oxide, indium zinc oxide, zinc indium tin oxide, antimony oxide, and mixtures thereof.

Materials suitable for use as the cathode include by zero valent metals which can inject negative charge carriers (electrons) into the inner layer(s) of the OLED. Various zero valent metals suitable for use as the cathode include K, Li, Na, Cs, Mg, Ca, Sr, Ba, Al, Ag, Au, In, Sn, Zn, Zr, Sc, Y, elements of the lanthanide series, alloys thereof, and mixtures thereof. Suitable alloy materials for use as the cathode layer include Ag-Mg, Al-Li, In-Mg, Al-Ca, and Al-Au alloys. Layered non-alloy structures may also be employed in the cathode, such as a thin layer of a metal such as calcium, or a metal fluoride, such as LiF, covered by a thicker layer of a zero valent metal, such as aluminum or silver. In particular, the cathode may be composed of a single zero valent metal, and especially of aluminum metal.

Materials suitable for use in hole transporting layers include 1,1-bis((di-4-tolylamino) phenyl)cyclohexane, N,N'- bis(4-methylphenyl)-N,N'-bis(4-ethylphenyl)-(1,1'-(3,3'-dimethyl)biphenyl)-4,4'-diamine, tetrakis-(3-methylphenyl)-N,N,N',N'-2,5-phenylenediamine, phenyl-4-N,N-diphenylaminostyrene, p-(diethylamino) benzaldehyde diphenylhydrazone, triphenylamine, 1-phenyl-3-(p-(diethylamino)styryl)-5-(p-(diethylamino)phenyl)pyrazoline, 1,2-trans-bis(9H-carbazol-9-yl)cyclobutane, N,N,N',N'-tetrakis(4-methylphenyl)-(1,1'-biphenyl)-4,4'-diamine, copper phthalocyanine, polyvinylcarbazole, (phenylmethyl)polysilane; poly(3,4- ethylendioxythiophene) (PEDOT), polyaniline, polyvinylcarbazole, triaryldiamine, tetraphenyldiamine, aromatic tertiary amines, hydrazone derivatives, carbazole derivatives, triazole derivatives, imidazole derivatives, oxadiazole derivatives having an amino group, and polythiophenes as disclosed in U.S. Pat. No. 6,023,371.

Materials suitable for use as the electron transport layer include poly(9,9-dioctyl fluorene), tris(8-hydroxyquinolato) aluminum (Alq₃), 2,9-dimethyl-4,7-diphenyl-1,1-phenanthroline, 4,7-diphenyl-1,10-phenanthroline, 2-(4-biphenylyl)-5-(4-t-butylphenyl)-1,3,4-oxadiazole, 3-(4-biphenylyl)-4-phenyl-5-(4-t-butylphenyl)-1,2,4- triazole, 1,3,4-oxadiazole-containing polymers, 1,3,4-triazole-containing polymers, quinoxaline-containing polymers, and cyano-PPV.

### DEFINITIONS

In the context of the present invention, alkyl is intended to include linear, branched, or cyclic hydrocarbon structures and combinations thereof, including lower alkyl and higher alkyl. Preferred alkyl groups are those of C₂₀ or below. Lower alkyl refers to alkyl groups of from 1 to 6 carbon atoms, preferably from 1 to 4 carbon atoms, and includes methyl, ethyl, *n*-propyl, isopropyl, and *n-, s-* and *t-* butyl. Higher alkyl refers to alkyl groups having seven or more carbon atoms, preferably 7-20 carbon atoms, and includes *n-, s*- and *t*-heptyl, octyl, and dodecyl. Cycloalkyl is a subset of alkyl and includes cyclic hydrocarbon groups of from 3 to 8 carbon atoms. Examples of cycloalkyl groups include cyclopropyl, cyclobutyl, cyclopentyl, and norbornyl. Alkenyl and alkynyl refer to alkyl groups wherein two or more hydrogen atoms are replaced by a double or triple bond, respectively.

Aryl and heteroaryl mean a 5- or 6-membered aromatic or heteroaromatic ring containing 0-3 heteroatoms selected from nitrogen, oxygen or sulfur; a bicyclic 9- or 10-membered aromatic or heteroaromatic ring system containing 0-3 heteroatoms selected from nitrogen, oxygen or sulfur; or a tricyclic 13- or 14-membered aromatic or heteroaromatic ring system containing 0-3 heteroatoms selected from nitrogen, oxygen or sulfur. The aromatic 6- to 14-membered carbocyclic rings include, for example, benzene, naphthalene, indane, tetralin, and fluorene; and the 5- to 10-membered aromatic heterocyclic rings include, e.g., imidazole, pyridine, indole, thiophene, benzopyranone, thiazole, furan, benzimidazole, quinoline, isoquinoline, quinoxaline, pyrimidine, pyrazine, tetrazole and pyrazole.

Arylalkyl means an alkyl residue attached to an aryl ring. Examples are benzyl and phenethyl. Heteroarylalkyl means an alkyl residue attached to a heteroaryl ring. Examples include pyridinylmethyl and pyrimidinylethyl. Alkylaryl means an aryl residue having one or more alkyl groups attached thereto. Examples are tolyl and mesityl.

Alkoxy or alkoxyl refers to groups of from 1 to 8 carbon atoms of a straight, branched, cyclic configuration and combinations thereof attached to the parent structure through an oxygen. Examples include methoxy, ethoxy, propoxy, isopropoxy, cyclopropyloxy, and cyclohexyloxy. Lower alkoxy refers to groups containing one to four carbons.

Acyl refers to groups of from 1 to 8 carbon atoms of a straight, branched, cyclic configuration, saturated, unsaturated and aromatic and combinations thereof, attached to the parent structure through a carbonyl functionality. One or more carbons in the acyl residue may be replaced by nitrogen, oxygen or sulfur as long as the point of attachment to the parent remains at the carbonyl. Examples include acetyl, benzoyl, propionyl, isobutyryl, *t*-butoxycarbonyl, and benzyloxycarbonyl. Lower-acyl refers to groups containing one to four carbons.

Heterocycle means a cycloalkyl or aryl residue in which one to three of the carbons is replaced by a heteroatom such as oxygen, nitrogen or sulfur. Examples of heterocycles that fall within the scope of the invention include pyrrolidine, pyrazole, pyrrole, indole, quinoline, isoquinoline, tetrahydroisoquinoline, benzofuran, benzodioxan, benzodioxole (commonly referred to as methylenedioxyphenyl, when occurring as a substituent), tetrazole, morpholine, thiazole, pyridine, pyridazine, pyrimidine, thiophene, furan, oxazole, oxazoline, isoxazole, dioxane, and tetrahydrofuran, triazole, benzotriazole, and triazine.

Substituted refers to structural units, including, but not limited to, alkyl, alkylaryl, aryl, arylalkyl, and heteroaryl, wherein up to three H atoms of the residue are replaced with lower alkyl, substituted alkyl, aryl, substituted aryl, haloalkyl, alkoxy, carbonyl, carboxy, carboxalkoxy, carboxamido, acyloxy, amidino, nitro, halo, hydroxy, OCH(COOH)₂, cyano, primary amino, secondary amino, acylamino, alkylthio, sulfoxide, sulfone, phenyl, benzyl, phenoxy, benzyloxy, heteroaryl, or heteroaryloxy; each of said phenyl, benzyl, phenoxy, benzyloxy, heteroaryl, and heteroaryloxy is optionally substituted with 1-3 substituents selected from lower alkyl, alkenyl, alkynyl, halogen, hydroxy, haloalkyl, alkoxy, cyano, phenyl, benzyl, benzyloxy, carboxamido, heteroaryl, heteroaryloxy, nitro or -NRR (wherein R is independently H, lower alkyl or cycloalkyl, and -RR may be fused to form a cyclic ring with nitrogen).

Haloalkyl refers to an alkyl residue, wherein one or more H atoms are replaced by halogen atoms; the term haloalkyl includes perhaloalkyl. Examples of haloalkyl groups that fall within the scope of the invention include CH₂F, CHF₂, and CF₃.

Silyl means an alkyl residue in which one to three of the carbons is replaced by tetravalent silicon and which is attached to the parent structure through a silicon atom. Siloxy is an alkoxy residue in which both of the carbons are replaced by tetravalent silicon that is endcapped with an alkyl residue, aryl residue or a cycloalkyl residue, and which is attached to the parent structure through an oxygen atom.

A bidentate ligand is a ligand that is capable of binding to metals through two sites. Similarly, a tridentate ligand is a ligand that is capable of binding to metals through three sites. Cyclometallated ligand means a bidentate or tridentate ligand bound to a metal atom by a carbon-metal single bond and one or two metal-heteroatom bonds, forming a cyclic structure, wherein the heteroatom may be N, S, P, As, or O.

Any numerical values recited herein include all values from the lower value to the upper value in increments of one unit provided that there is a separation of at least 2 units between any lower value and any higher value. As an example, if it is stated that the amount of a component or a value of a process variable such as, for example, temperature, pressure, time and the like is, for example, from 1 to 90, preferably from 20 to 80, more preferably from 30 to 70, it is intended that values such as 15 to 85, 22 to 68, 43 to 51, 30 to 32 etc. are expressly enumerated in this specification. For values which are less than one, one unit is considered to be 0.0001, 0.001, 0.01 or 0.1 as appropriate. These are only examples of what is specifically intended and all possible combinations of numerical values between the lowest value and the highest value enumerated are to be considered to be expressly stated in this application in a similar manner.

### EXPERIMENTAL

General: Molecular weight data was obtained using Perkin Elmer GPC Series 200 with UV/VIS Detector, Polymer Laboratories PLGel 5 mm column, Chloroform as eluent, and polystyrene standards as the calibration standards. NMR spectroscopy was performed on Bruker 400MHz instrument. Glass pre-coated with indium tin oxide (ITO) was obtained from Applied Films. Poly (3,4-ethylendioxythiophene) /polystyrene sulfonate (PEDOT:PSS) was purchased from H.C. Starck Co., GmbH, Leverkusen, Germany. 2-(9-Carbazolyl)-ethyl methacrylate and 2-(9-carbazolyl)-ethyl acrylate were obtained from Aldrich Chemical Co., and used as received. Iridium (III) bis(2-(4,6-difluorephenyl)pyridinato-N,C2) (FIrpic) purchased from American Dye Source, Inc, Quebec, Canada, was used as an electrophosphorescent dye. 1,3-Bis[5-(4-(1,1-dimethylethyl)phenyl)-1,3,4-oxadiazol-2-yl]benzene (OXD-7) purchased from H.W. Sands was used as an electron transport material. Polyvinyl carbazole (PVK) purchased from Aldrich was used as a control host.

### Example 1: Synthesis of poly(2-(9-carbazolyl)-ethyl acrylate)]

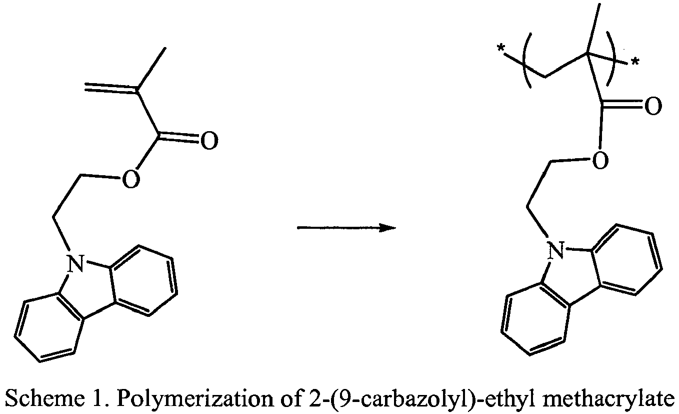

In a round bottom flask, 2-(9-carbazolyl)-ethyl methacrylate (2 grams (g)) was dissolved in 4 milliliters (mL) of N-methyl pyrrolidinone (NMP). To this solution, 20 microliters (µl) of azobisisobutyronitrile (AIBN) in NMP solution (0.1 g/mL) was added. The flask was degassed by freeze thaw cycle (x3) and the polymerization was allowed to proceed at 65 °C overnight. Then, the reaction mixture was cooled to room temperature. Subsequently, 30 mL of methylene chloride was added to the reaction mixture to dilute the solution. This mixture was then added drop wise to 300 mL of methanol in a blender, during which time a white powder precipitated from solution. The precipitated polymer was collected by vacuum filtration. The polymer was then redissolved in 40 mL of chloroform and reprecipitated out of 300 mL of acetone. Again the polymer was collected using vacuum filtration, and was then vacuum dried overnight. GPC analysis of the polymer indicated that it had a weight average molecular weight Mw of 141,500, and polydispersity index PDI of 2.12.

### Example 2: Synthesis of poly(2-(9-carbazolyl)-ethyl acrylate)

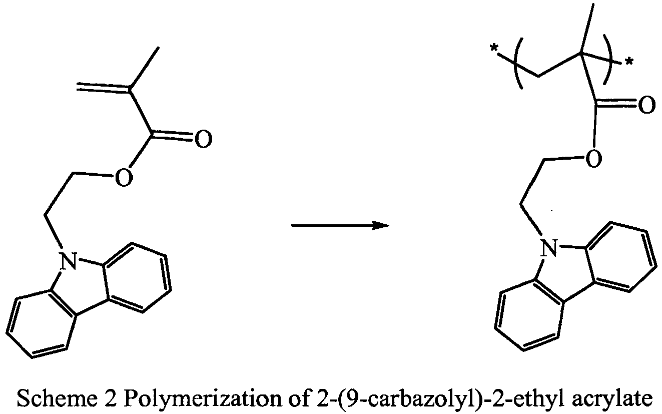

To a round bottom flask, 2-(9-carbazolyl)-ethyl acrylate (0.4 g) was dissolved in 2 mL of NMP. To this solution, 5 µl of AIBN in NMP solution (0.1 g/mL) was added. The flask was degassed by freeze thaw cycle (x3) and the polymerization was allowed to proceed overnight at 65 °C. Then, the reaction mixture was cooled to room temperature. Subsequently, 3 mL of methylene chloride was added to the reaction mixture to dilute the solution. This mixture was then added drop wise to 200 mL of methanol in a blender to precipitate the polymer as a white powder, which was then collected through vacuum filtration. The collected polymer was redissolved into 5 mL of chloroform and reprecipitated out from 100 mL of methanol. The polymer was then collected using vacuum filtration, which was then vacuum dried overnight at room temperature to afford 0.36 g of the polymer. GPC analysis of the polymer indicated that it had an Mw of 13,000, and a PDI of 1.5. DSC analysis showed that the polymer had a glass transition temperature Tg of 101 °C.

### Example 3

### General procedure for obtaining phosphorescent spectra

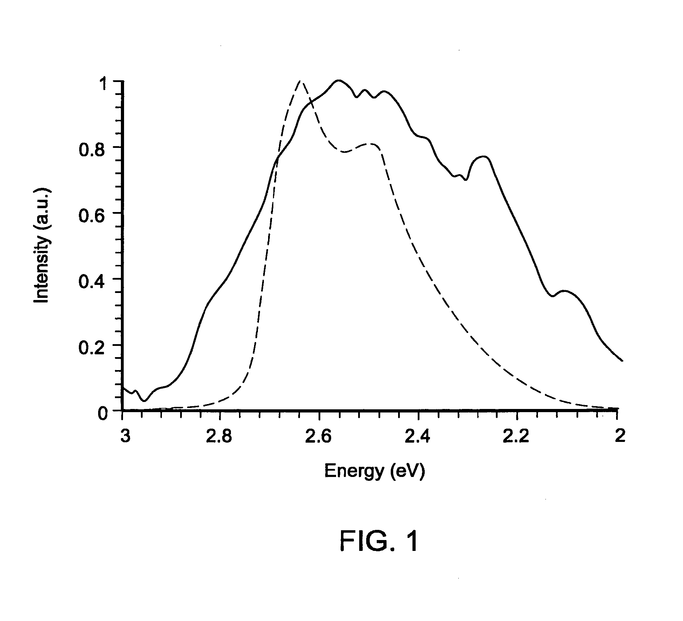

Phosphorescent spectra were obtained using a Perkin Elmer LS55 spectro-fluorimeter equipped with an uncooled R928 red sensitive photo multiplier tube. The typical procedure involved placing a sample of the polymer in a clean laboratory mortar and immersing the sample in liquid nitrogen at least 2 minutes prior to the measurement to ensure thermal equilibrium. Then the sample was optically excited. Emission spectra were obtained by using the delayed collection feature of the LS55, in which the detection is gated at time delayed from the initial 20 microseconds (µs) excitation pulse. The phosphorescent spectra of poly(2-(9-carbazolyl)-ethyl methacrylate) and FIrpic (1wt%) dispersed in polystyrene (PS) are shown in Figure 1.

### General procedure for determination of lifetime of triplet excited states of FIrpic

The lifetime of triplet excited states were measured using an Edinburgh CD920 spectrometer equipped with a cooled R928 photo multiplier tube. The typical procedure was to place a sample under a vacuum 4*10E⁻⁵ torr in a vacuum dewar. Then the sample was optically excited at 394nm with a pulsed diode laser (pulse width 55 ps, repetition rate 10-40 kHz, 1-50 nJ per pulse). Time resolved emission spectra were measured at 470nm.

Samples for the lifetime of triplet excited states measurement were prepared as follows:
Sample 1: A mixture of 1 weight percent (wt%) (0.39 mol%) FIrpic in poly(2-(9-carbazolyl)-ethyl methacrylate) from example 1 was prepared by mixing 0.010 mL of 1 wt% FIrpic (10mg of FIrpic in 1ml tetrahydrofuran (THF)) (0.1 mg Firpic, ).0014 mmol) with 1.0 mL of 1 wt% poly(9-carbazolyl)-ethyl methacrylate (0.01g (9-carbazolyl)-ethyl methacrylate structural unit, 0.036 mmol) in THF. The solution was then spin-coated onto a pre-cleaned quartz substrate.
Sample 2: A mixture of 1 wt% FIrpic in poly(2-(9-carbazolyl)-ethyl acrylate) from example 2 was prepared by mixing 0.010 mL of 1 wt% FIrpic (10 mg of FIrpic in 1ml THF) with 1.0 mL of 1 wt% poly(2-(9-carbazolyl)-ethyl acrylate) in THF. The solution was then spin-coated onto a pre-cleaned quartz substrate.
Sample 3: A mixture of 1 wt% FIrpic in PS was prepared by mixing 0.010 mL of 1 wt% FIrpic (10 mg of FIrpic in 1 mL THF) with 1.0mL of 1 wt% PS in THF. The solution was spin-coated onto a pre-cleaned quartz substrate.
Sample 4: A mixture of 1 wt% FIrpic in poly(vinyl carbazole) (PVK) was prepared by mixing of 0.010 mL of 1 wt% FIrpic (10 mg of FIrpic in 1 mL THF) with 1.0 ml of 1 wt% PVK in THF. The solution was spin-coated onto a pre-cleaned quartz substrate.

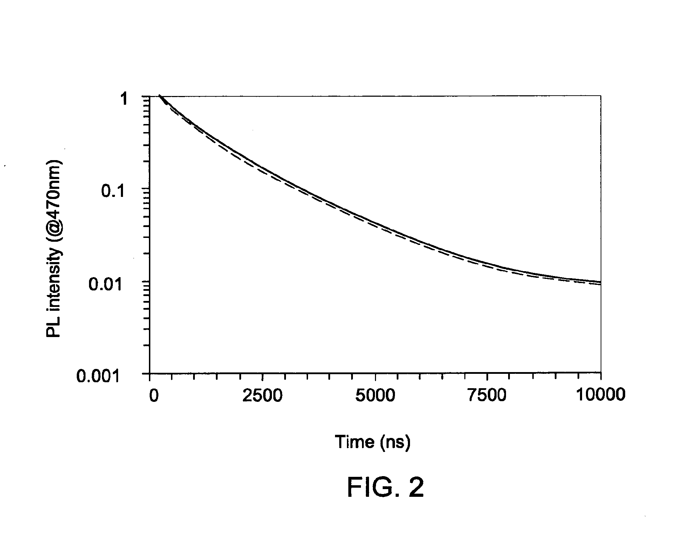

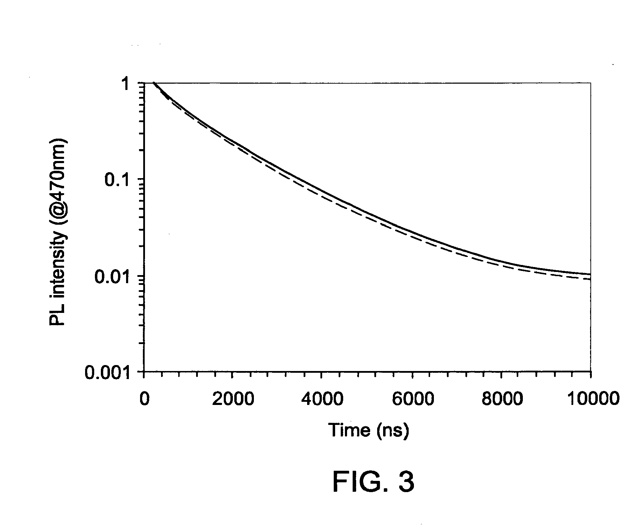

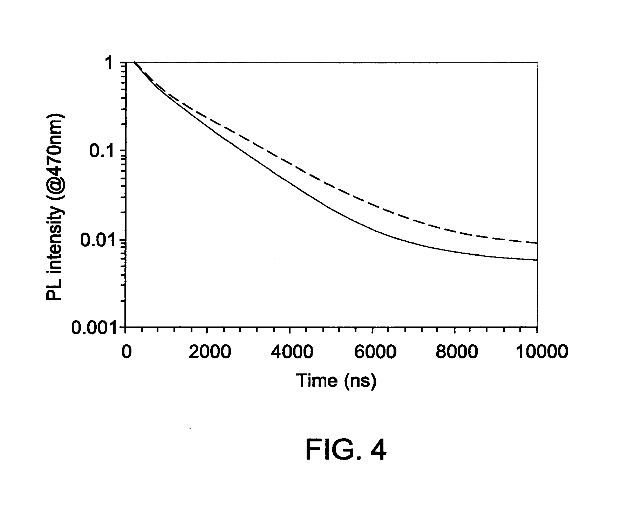

It can be seen from Figures 2-4, the phosphorescent dye (FIrpic) has comparable triplet decay profiles (equivalent lifetimes) when dispersed in poly(2-(9-carbazolyl)-ethyl methacrylate) and poly(2-(9-carbazolyl)-ethyl acrylate) relative to an insulating PS matrix. The data is consistent with the results of triplet energy measurements - there was no measurable energy back transfer from the dye FIrpic to the host materials. Note that energy back transfer from FIrpic to PVK is evidenced by the faster photoluminescent (PL) decay of the PVK:FIrpic mixture relative to the PS:FIrpic mixture (Figure 4). These results clearly show that both poly(2-(9-carbazolyl)-ethyl methacrylate) and poly(2-(9-carbazolyl)-ethyl acrylate) are excellent choices as host materials for FIrpic.

### Example 4: Blue phosphorescent organic light emitting devices (OLEDs)

Two phosphorescent OLEDs were fabricated, one is the control having a structure of ITO/PEDOT:PSS/PVK:FIrpic:OXD-7/CsF/A1 and the other is an exemplary device with the poly(2-(9-carbazolyl)-ethyl methacrylate) in place of PVK. A solution of poly(2-(9-carbazolyl)-ethyl methacrylate): FIrpic:OXD-7 (100:10:30) was prepared by mixing 1.0 milliliter of 2.0 wt% of poly(2-(9-carbazolyl)-ethyl methacrylate) in chlorobenzene, 0.20 milliliter of 1.0wt% of FIrpic in chlorobenzene and 0.30 milliliter of 2.0 wt% OXD-7 in chlorobenzene. Similarly, a solution of PVK:FIrpic:OXD-7 (100:10:30) was prepared by mixing PVK , FIrpic and OXD-7 solutions.

The OLEDs were fabricated as follows: Pre-patterned ITO coated glass used as the anode substrate was cleaned with UV-ozone for 10mins. Then a 60 nanometer (nm) layer of PEDOT:PSS was deposited atop the ITO via spin-coating and then baked for 1 hour at 180°C in air. The samples were then transferred into a glovebox filled with argon (both moisture and oxygen were less than 1 ppm). Then the solutions were spin-coated atop the PEDOT:PSS layer and baked on a hotplate (preheated to 80°C) for 10 mins. Next, a CsF (4 nanometer)/Al (130 nanometer) bilayer cathode was thermally-evaporated onto the mixture layer. After metallization, the devices were encapsulated with a cover glass sealed with Norland 68 optical adhesive obtained from Norland products, Inc, Cranbury, NJ 08512, USA. The active area is about 0.2cm².

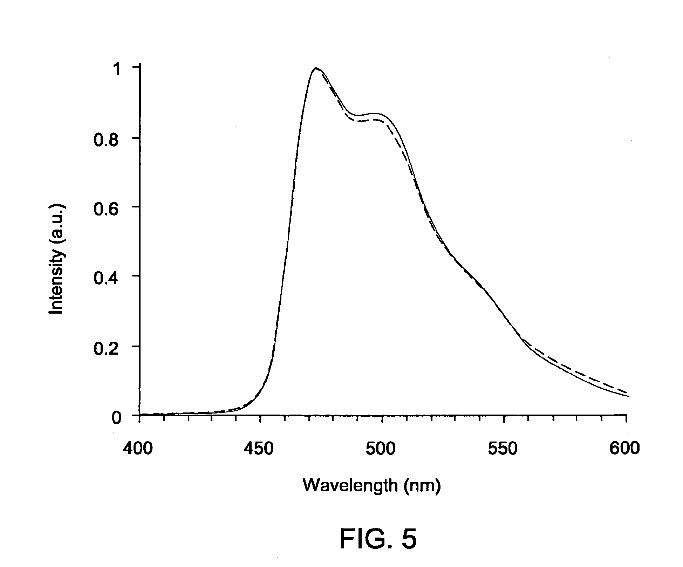

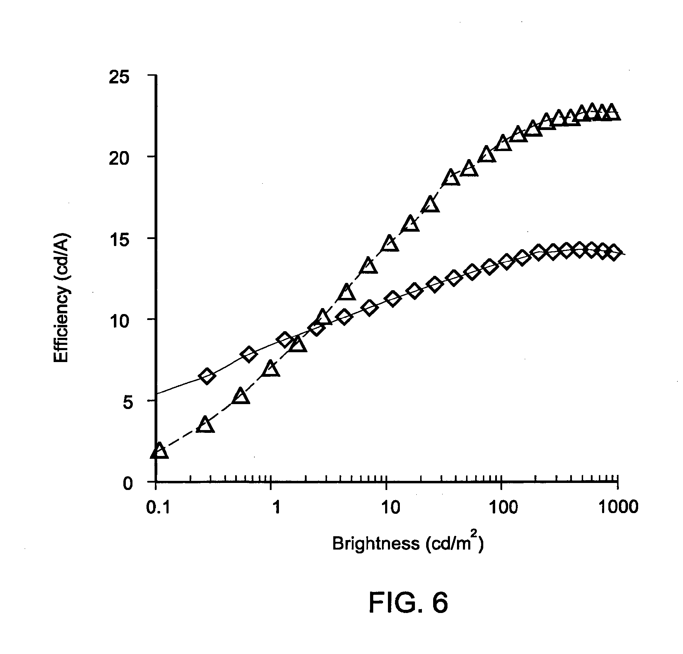

The OLEDs emit similar blue light (Figure 5). Performance of such OLEDs is shown in Figure 6. It can be seen that the exemplary device with poly(2-(9-carbazolyl)-ethyl methacrylate) as the host exhibits higher efficiency with respect to the control with PVK as the host.

While only certain features of the invention have been illustrated and described herein, many modifications and changes will occur to those skilled in the art. It is, therefore, to be understood that the appended claims are intended to cover all such modifications and changes as fall within the true spirit of the invention.

## Claims

1. A composition comprising at least one phosphorescent organometallic compound and a polymer comprising structural units derived from at least one monomer of formula I 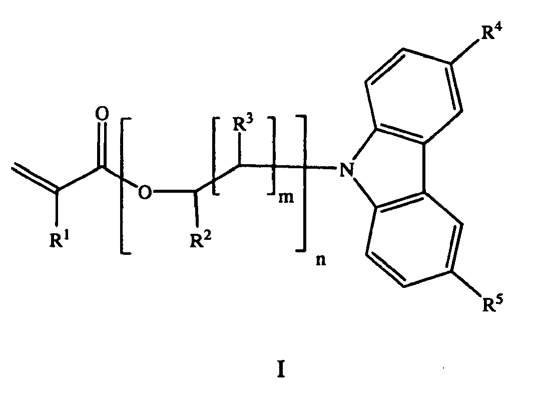 wherein
R¹ is H or CH₃;
R² is H or C₁-C₅ alkyl;
R³ is H or CH₃;
R⁴ and R⁵ are independently H, CH₃, t-butyl, triarylsilyl, trialkylsilyl, diphenyl phosphine oxide, or diphenyl phosphine sulfide;
m ranges from 1 to about 20; and
n ranges from 1 to about 20;
wherein the at least one phosphorescent organometallic compound has formula L₂MZ;
L and Z are independently bidentate ligands derived from phenylpyridine, tolylpyridine, benzothienylpyridine, phenylisoquinoline, dibenzoquinozaline, fluorenylpyridine, ketopyrrole, picolinate, acetylacetonate hexafluoroacetylacetonate, salicylidene, 8-hydroxyquinolinate, salicylaldehyde, iminoacetonate, 2-(1-naphthyl)benzoxazole)), 2-phenylbenzoxazole, 2-phenylbenzothiazole, coumarin, thienylpyridine, phenylpyridine, benzothienylpyridine, 3-methoxy-2-phenylpyridine, thienylpyridine, phenylimine, vinylpyridine, pyridylnaphthalene, pyridylpyrrole, pyridylimidazole, phenylindole, derivatives thereof or combinations thereof; and
M is Ga, Al, Sc, Ti, V, Cr, Mn, Fe, Co, Ni, Cu, Zn, Y, Zr, Nb, Mo, Tc, Ru, Rh, Pd, Ag, Cd, Lu, Hf, Ta, W, Re, Os, Ir, Pt, Au, Hg, Ga, Ge, In, Sn, Sb, Tl, Pb, Bi, Eu, Tb, La, Po, or a combination thereof.

2. The composition of claim 1, wherein the polymer comprises structural units derived from at least one monomer of formula 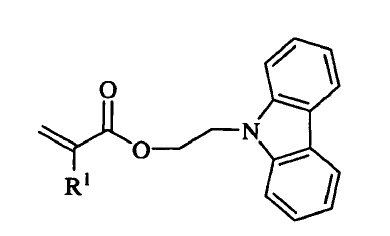 wherein R¹ is H or CH₃.

3. The composition of claim 1, wherein the polymer further comprises structural units derived from acrylic acid, esters of acrylic acid, acrylic amides, methacrylic acid, esters of methacrylic acid, methacrylic amides, or a combination thereof.

4. The composition of claim 1, wherein M is Ir.

5. The composition of claim 1, wherein L is a cyclometallated ligand.

6. The composition of claim 1, wherein L is derived from 2-(4,6-difluorophenyl)pyridine.

7. The composition of claim 1, wherein Z is derived from picolinate.

8. The composition of claim 1, wherein the at least one phosphorescent organometallic compound is a compound of formula 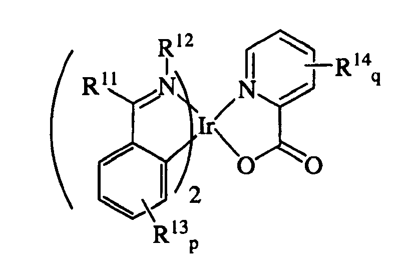 wherein
R¹¹ and R¹² taken together form a substituted or unsubstituted monocyclic or bicyclic heteroaromatic ring;
R¹³ and R¹⁴ are independently at each occurrence halo, nitro, hydroxy, amino, alkyl, aryl, arylalkyl, alkoxy, substituted alkoxy, substituted alkyl, substituted aryl, or substituted arylalkyl;
p and q are independently 0, or an integer ranging from 1 to 4.

9. The composition of claim 1, wherein the at least one phosphorescent organometallic compound is

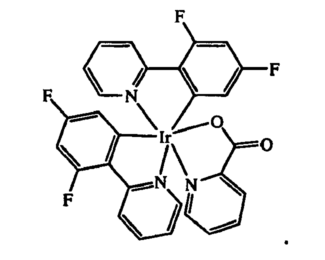

10. The composition of claim 1, wherein the at least one phosphorescent organometallic compound is a blue phosphorescent dye, a green phosphorescent dye, or a red phosphorescent dye.

11. A composition according to claim 1, wherein the phosphorescent organometallic compound is a compound of formula 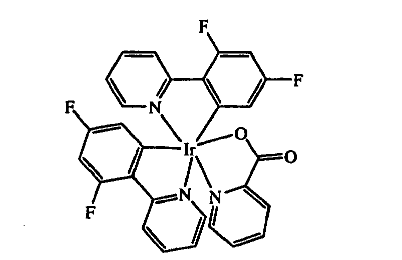 and the polymer comprises structural units derived from a monomer of formula

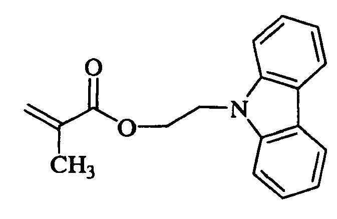

12. A composition according to claim 1, wherein the phosphorescent organometallic compound is a compound of formula 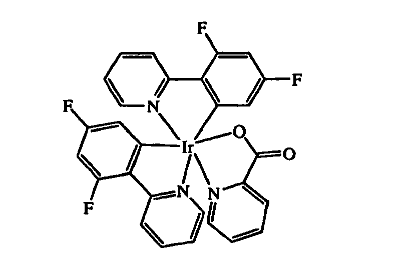 and the polymer comprises structural units derived from a monomer of formula

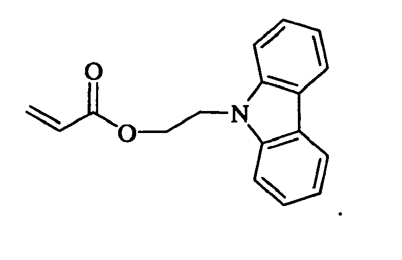

13. An organic light emitting device comprising:
at least one electrode;
at least one charge injection layer; and
at least one light emissive layer comprising a composition as defined in any preceding claim.

## Patentansprüche

1. Zusammensetzung umfassend mindestens eine phosphoreszierende organometallische Verbindung und ein Polymer, das strukturelle Einheiten umfasst, die von mindestens einem Monomer der Formel I abgeleitet sind 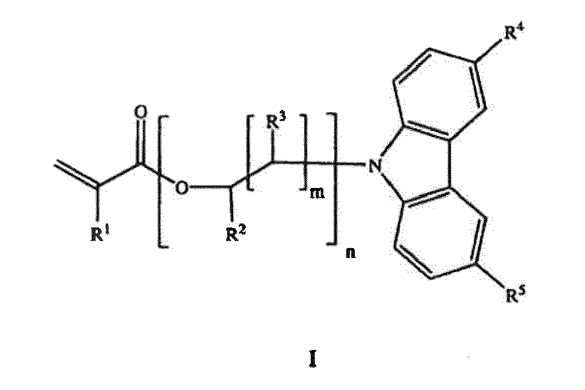 wobei
R¹ H oder CH₃ ist;
R² H oder C₁-C₃-Alkyl ist;
R³ H oder CH₃ ist;
R⁴ und R⁵ unabhängig H oder CH₃, tert.-Butyl, Triarylsilyl, Trialkylsilyl, Diphenylphosphinoxid oder Diphenylphosphinsulfid sind;
m im Bereich vom 1 bis etwa 20 liegt; und
n im Bereich von 1 bis etwa 20 liegt;
wobei die mindestens eine phosphoreszierende organometallische Verbindung die Formel L₂MZ aufweist;
L und Z unabhängig zweizähnige Liganden sind, die von Phenylpyridin, Tolylpyridin, Benzothienylpyridin, Phenylisochinolin, Dibenzochinoxalin, Fluorenylpyridin, Ketopyrrol, Picolinat, Acetylacetonat, Hexafluoracetylacetonat, Salicyliden, 8-Hydroxychinolinat, Salicylaldehyd, Iminoacetonat, 2-(1-Naphthyl)benzoxazol, 2-Phenylbenzoxazol, 2-Phenylbenzothiazol, Cumarin, Thienylpyridin, Phenylpyridin, Benzothienylpyridin, 3-Methoxy-2-phenylpyridin, Thienylpyridin, Phenylimin, Vinylpyridin, Pyridylnaphthalin, Pyridylpyrrol, Pyridylimidazol, Phenylindol, Derivaten davon oder Kombinationen davon abgeleitet sind; und
M Ga, Al, Sc, Ti, V, Cr, Mn, Fe, Co, Ni, Cu, Zn, Y, Zr, Nb, Mo, Tc, Ru, Rh, Pd, Ag, Cd, Lu, Hf, Ta, W, Re, Os, Ir, Pt, Au, Hg, Ga, Ge, In, Sn, Sb, Tl, Pb, Bi, Eu, Tb, La, Po oder eine Kombination davon ist.

2. Zusammensetzung nach Anspruch 1, wobei das Polymer strukturelle Einheiten umfasst, die von mindestens einem Monomer der Formel 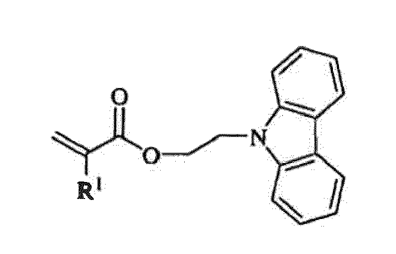 abgeleitet sind, wobei R¹ H oder CH₃ ist.

3. Zusammensetzung nach Anspruch 1, wobei das Polymer des Weiteren strukturelle Einheiten umfasst, die von Acrylsäure, Estern von Acrylsäure, Acrylamiden, Methacrylsäure, Estern von Methacrylsäure, Methacrylamiden oder einer Kombination davon abgeleitet sind.

4. Zusammensetzung nach Anspruch 1, wobei M Ir ist.

5. Zusammensetzung nach Anspruch 1, wobei L ein cyclometallierter Ligand ist.

6. Zusammensetzung nach Anspruch 1, wobei L von 2-(4,6-Difluorphenyl)pyridin abgeleitet ist.

7. Zusammensetzung nach Anspruch 1, wobei Z von Picolinat abgeleitet ist.

8. Zusammensetzung nach Anspruch 1, wobei die mindestens eine phosphoreszierende organometallische Verbindung eine Verbindung der Formel 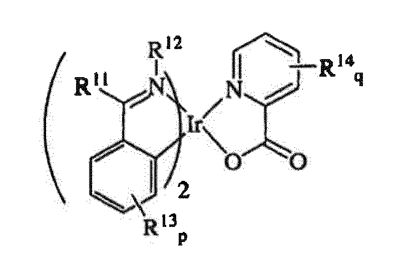 ist,
wobei
R¹¹ und R¹² zusammengenommen einen substituierten oder unsubstituierten monocyclischen oder bicyclischen heteroaromatischen Ring bilden;
R¹³ und R¹⁴ unabhängig bei jedem Vorkommen Halo, Nitro, Hydroxy, Amino, Alkyl, Aryl, Arylalkyl, Alkoxy, substituiertes Alkoxy, substituiertes Alkyl, substituiertes Aryl oder substituiertes Arylalkyl sind;
p und q unabhängig 0 oder eine ganze Zahl im Bereich von 1 bis 4 sind.

9. Zusammensetzung nach Anspruch 1, wobei die mindestens eine phosphoreszierende organometallische Verbindung 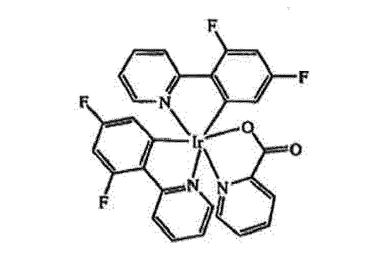 ist.

10. Zusammensetzung nach Anspruch 1, wobei die mindestens eine phosphoreszierende organometallische Verbindung ein blauer phosphoreszierender Farbstoff, ein grüner phosphoreszierender Farbstoff oder ein roter phosphoreszierender Farbstoff ist.

11. Zusammensetzung nach Anspruch 1, wobei die phosphoreszierende organometallische Verbindung eine Verbindung der Formel 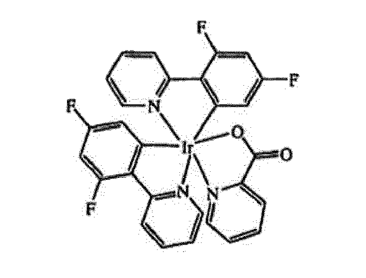 ist und das Polymer strukturelle Einheiten umfasst, die von einem Monomer der Formel 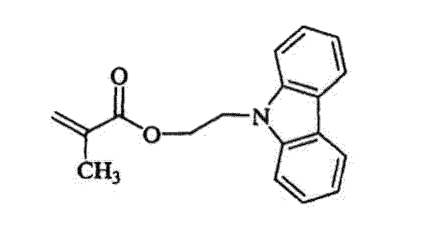 abgeleitet sind.

12. Zusammensetzung nach Anspruch 1, wobei die phosphoreszierende organometallische Verbindung eine Verbindung der Formel 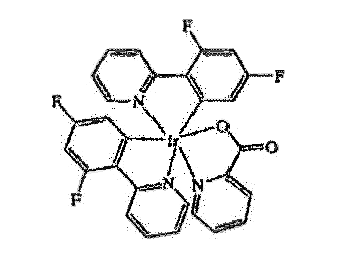 ist und das Polymer strukturelle Einheiten umfasst, die von einem Monomer der Formel 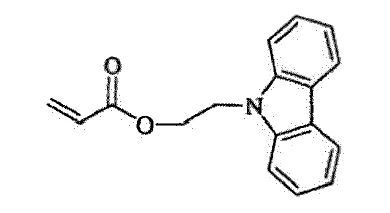 abgeleitet sind.

13. Organische lichtemittierende Vorrichtung umfassend:
mindestens eine Elektrode;
mindestens eine Ladungsinjektionsschicht; und
mindestens eine lichtausstrahlende Schicht umfassend eine Zusammensetzung wie in einem der vorhergehenden Ansprüche definiert.

## Revendications

1. Composition comprenant au moins un composé organométallique phosphorescent et un polymère comprenant des unités structurelles dérivées d'au moins un monomère de formule I : 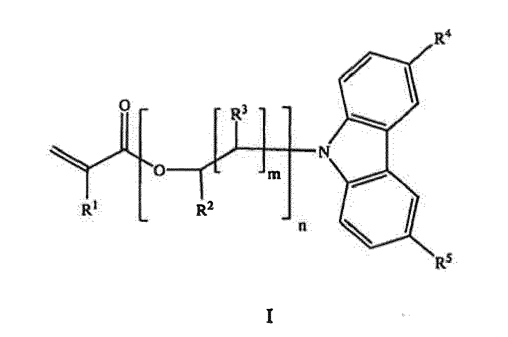 dans laquelle :
R¹ est H ou CH₃ ;
R² est H ou un groupement alkyle en C₁-C₅ ;
R³ est H ou CH₃ ;
R⁴ et R⁵ sont indépendamment H, CH₃, un groupement t-butyle, triarylsilyle, trialkylsilyle, oxyde de diphénylphosphine ou sulfure de diphénylphosphine ;
m se situe dans une plage de 1 à environ 20 ; et
n se situe dans une plage de 1 à environ 20.
dans laquelle le au moins un composé organométallique phosphorescent a pour formule L₂MZ ;
L et Z sont indépendamment des ligands bidentates dérivés de la phénylpyridine, de la tolylpyridine, de la benzothiénylpyridine, de la phényl-isoquinoléine, de la dibenzoquinozaléine, de la fluorénylpyridine, du cétopyrrole, du picolinate, de l'acétylacétonate, de l'hexafluoroacétylacétonate, du salicylidène, du 8-hydroxyquinoléinate, du salicylaldéhyde, de l'iminoacétonate, du 2-(1-naphtyl)benzoxazole)), du 2-phénylbenzoxazole, du 2-phénylbenzothiazole, de la coumarine, de la thiénylpyridine, de la phénylpyridine, de la benzothiénylpyridine, de la 3-méthoxy-2-phénylpyridine, de la thiénylpyridine, de la phénylimine, de la vinylpyridine, du pyridylnaphtalène, du pyridylpyrrole, du pyridylimidazole, du phénylindole, de leurs dérivés ou de leurs combinaisons ; et
M est Ga, Al, Sc, Ti, V, Cr, Mn, Fe, Co, Ni, Cu, Zn, Y, Zr, Nb, Mo, Tc, Ru, Rh, Pd, Ag, Cd, Lu, Hf, Ta, W, Re, Os, Ir, Pt, Au, Hg, Ga, Ge, In, Sn, Sb, Tl, Pb, Bi, Eu, Tb, La, Po ou une de leurs combinaisons.

2. Composition selon la revendication 1, dans laquelle le polymère comprend des unités structurelles dérivées d'au moins un monomère de formule : 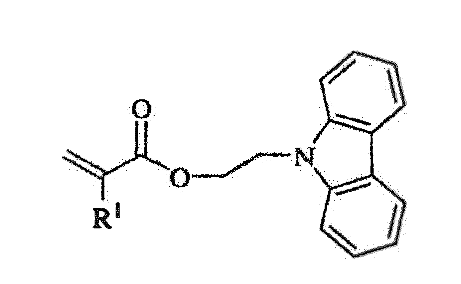 dans laquelle R¹ est H ou CH₃.

3. Composition selon la revendication 1, dans laquelle le polymère comprend en outre des unités structurelles dérivées de l'acide acrylique, des esters de l'acide acrylique, des amides acryliques, de l'acide méthacrylique, des esters de l'acide méthacrylique, des amides méthacryliques ou d'une combinaison de ceux-ci.

4. Composition selon la revendication 1, dans laquelle M est Ir.

5. Composition selon la revendication 1, dans laquelle L est un ligand cyclométallaté.

6. Composition selon la revendication 1, dans laquelle L est dérivé de la 2-(4,6-difluoro-phényl)pyridine.

7. Composition selon la revendication 1, dans laquelle Z est dérivé d'un picolinate.

8. Composition selon la revendication 1, dans laquelle le au moins un composé organométallique phosphorescent est un composé de formule : 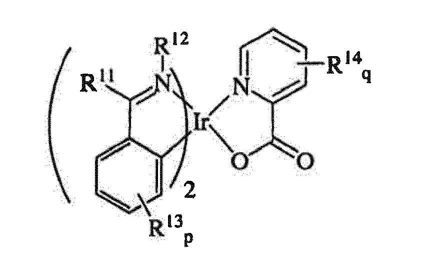 dans laquelle :
R¹¹ et R¹², pris conjointement, forment un noyau hétéroaromatique monocyclique ou bicyclique substitué ou non substitué ;
R¹³ et R¹⁴ sont indépendamment à chaque occurrence un groupement halo, nitro, hydroxy, amino, alkyle, aryle, arylalkyle, alcoxy, alcoxy substitué, alkyle substitué, aryle substitué ou arylalkyle substitué ;
p et q sont indépendamment 0 ou un nombre entier allant de 1 à 4.

9. Composition selon la revendication 1, dans laquelle le au moins un composé organométallique phosphorescent est un composé de formule :

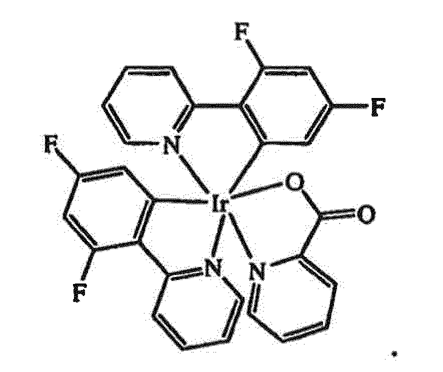

10. Composition selon la revendication 1, dans laquelle le au moins un composé organométallique phosphorescent est un colorant phosphorescent bleu, un colorant phosphorescent vert ou un colorant phosphorescent rouge.

11. Composition selon la revendication 1, dans laquelle le au moins un composé organométallique phosphorescent est un composé de formule : 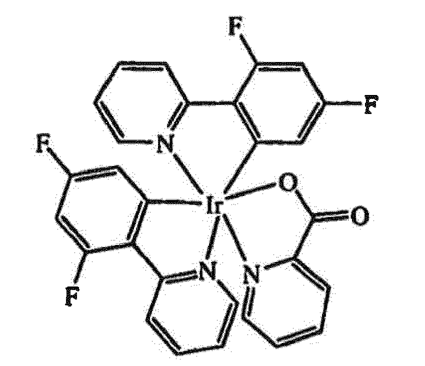 et le polymère comprend des unités structurelles dérivées d'un monomère de formule :

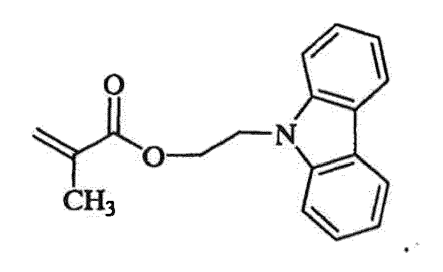

12. Composition selon la revendication 1, dans laquelle le au moins un composé organométallique phosphorescent est un composé de formule : 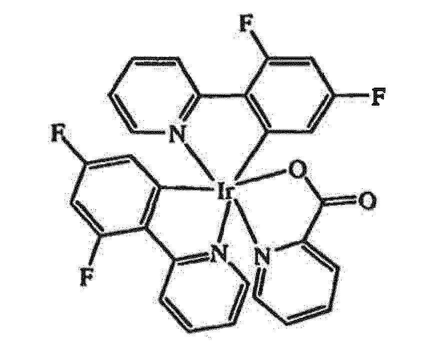 et le polymère comprend des unités structurelles dérivées d'un monomère de formule :

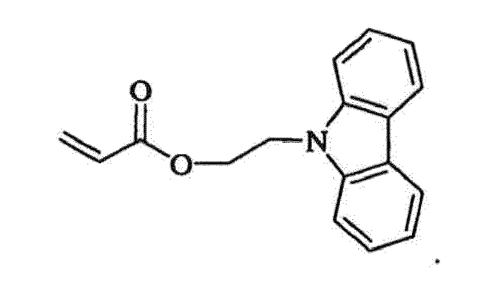

13. Dispositif organique électroluminescent comprenant :
au moins une électrode ;
au moins une couche d'injection de charges ; et
au moins une couche électroluminescente comprenant une composition selon l'une quelconque des revendications précédentes.
